(19) Europäisches Patentamt
European Patent Office
Office européen des brevets

(11) Veröffentlichungsnummer: **0 278 996**
**A1**

## (12) EUROPÄISCHE PATENTANMELDUNG

(21) Anmeldenummer: **87102190.3**

(22) Anmeldetag: **17.02.87**

(51) Int. Cl.⁴: **G03F 7/02**

(43) Veröffentlichungstag der Anmeldung: **24.08.88 Patentblatt 88/34**

(84) Benannte Vertragsstaaten: **DE FR GB IT**

(71) Anmelder: **IBM DEUTSCHLAND GMBH**
**Pascalstrasse 100**
**D-7000 Stuttgart 80(DE)**

⑧④ **DE**

(71) Anmelder: **International Business Machines Corporation**
**Old Orchard Road**
**Armonk, N.Y. 10504(US)**

⑧④ **FR GB IT**

(72) Erfinder: **Bayer, Thomas**
**Hinterweiler Strasse 45**
**D-7032 Sindelfingen(DE)**
Erfinder: **Greschner, Johann, Dr.**
**Tiergartenweg 14**
**D-7401 Pliezhausen 1(DE)**
Erfinder: **Wolter, Olaf, Dr.**
**Herdlauchring 43**
**D-7036 Schönaich(DE)**

(74) Vertreter: **Kreidler, Eva-Maria, Dr. rer. nat.**
**IBM Deutschland GmbH Patentwesen und Urheberrecht Schönaicher Strasse 220**
**D-7030 Böblingen(DE)**

## (54) Verfahren zur Verbesserung der Haftung von Photoresistmaterialien.

(57) Die Erfindung betrifft ein Verfahren zur Verbesserung der Haftung von Photoresistmaterialien auf Oberflächen von anorganischen Substratmaterialien. In diesem Verfahren wird eine siliciumorganische Verbindung der allgemeinen Formel

EP 0 278 996 A1

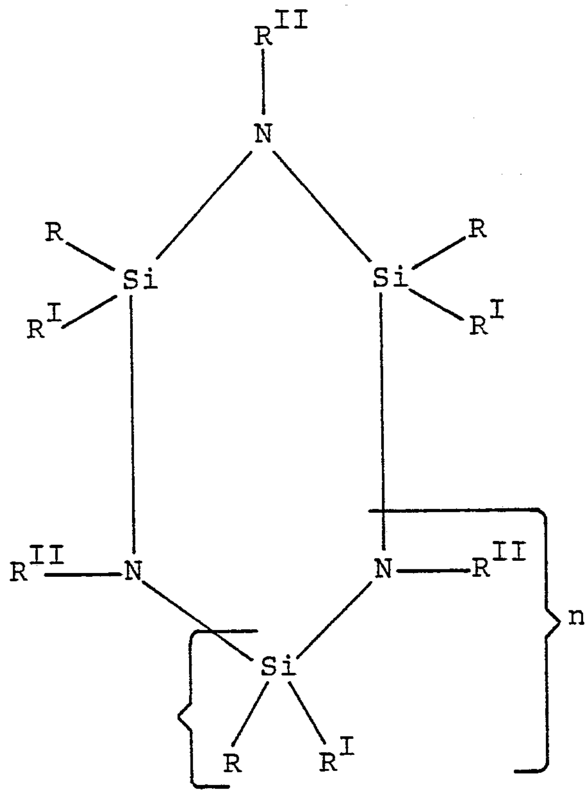

in der R und $R^I$ jeweils H, Alkyl, Cycloalkyl, Aryl, halogensubstituiertes Alkyl oder Aryl, oder Halogen und $R^{II}$ jeweils H, Alkyl oder Aryl bedeuten und n eine ganze Zahl und vorzugsweise 1 oder 2 ist, auf die Oberfläche des Substratmaterials aufgetragen, welches anschliessend mit dem Photoresist beschichtet wird. Bevorzugter Haftvermittler ist Hexamethylcyclotrisilazan, welcher dem bisher verwendeten Hexamethyldisilazan weit überlegen ist.

Die Vorteile des erfindungsgemässen Verfahrens kommen insbesondere bei der Herstellung mikromechanischer Strukturen, bei denen Ätzmasken aus Siliciumdioxid mit einer sehr grossen Schichtdicke von einigen µm hergestellt werden müssen, zum Tragen.

## Verfahren zur Verbesserung der Haftung von Photoresistmaterialien

Die Erfindung betrifft ein Verfahren zur Verbesserung der Haftung von Photoresistmaterialien auf Oberflächen von anorganischen Substratmaterialien. Als solche kommen beispielsweise polykristallines Silicium, Siliciumnitrid, Siliciumoxinitrid, Siliciumdioxid, Quarz, Phosphorsilikatglas und dergl. in Frage.

Bei der Herstellung von strukturierten Vorrichtungen wie Halbleiterchips oder Chipträgern gehören die Prozesschritte des Ätzens verschiedener Schichten, aus denen das Endprodukt aufgebaut ist, zu den kritischsten Schritten überhaupt. Ein Verfahren, das in grossem Umfang angewendet wird, besteht darin, die zu ätzende Oberfläche eines Substrats mit einer geeigneten Maske zu versehen und das Substrat mit der Maske in eine chemische Lösung zu tauchen, welche das Substratmaterial angreift, während die Maske selbst intakt bleibt. So kann beispielsweise auf einem Halbleitersubstrat aus Silicium eine Siliciumdioxidmaske erzeugt werden, indem eine gleichförmige Oxidschicht auf dem Halbleitersubstrat gebildet wird und anschliessend eine Reihe von Oeffnungen in der Oxidschicht erzeugt werden. Hierzu wird die Oxidschicht mit einer Photoresistschicht überzogen, welche selektiv belichtet wird. In einem Lösungsmittel werden, im Falle eines negativen Resists die nichtbelichteten Bereiche und, im Falle eines positiven Resists die belichteten Bereiche der Photoresistschicht entfernt. Anschliessend werden die nichtgeschützten Bereiche der Oxidschicht in einem geeigneten Ätzmittel, beispielsweise Flussäure geätzt.

Es wurde nun gefunden, dass der Photoresist während der Ätzung der Siliciumdioxidschicht von der Flussäure unterwandert wird und die Maske die Tendenz zeigt, sich an ihren Rändern von der Oxidoberfläche abzulösen. Dies führt dazu, dass zusätzliche Bereiche der Oxidschicht dem Ätzmittel ausgesetzt werden und letztere unmittelbar unterhalb der Ränder des sich abhebenden Photoresists geätzt wird, woraus eine Unschärfe der Kanten an den geätzten Oberflächen resultiert.

Auch bei der Herstellung mikromechanischer Strukturen aus Silicium werden Ätzmasken aus Siliciumdioxid verwendet. Diese müssen, weil sie einem Angriff des Ätzmittels für Silicium über viele Stunden standzuhalten haben, in einer im Vergleich zur Halbleitertechnologie sehr grossen Schichtdicke von einigen µm hergestellt werden. Viele mikromechanische Strukturen werden auch hergestellt, indem sie direkt aus einer Siliciumdioxidschicht herausgearbeitet werden.

Bei der Herstellung der für die Mikromechanik benötigten Ätzmasken aus Siliciumdioxid sind wegen ihrer grossen Schichtdicke die Probleme, die im Zusammenhang mit der Haftung der Photoresistmaterialien auf der Oxidoberfläche während der Einwirkung des Ätzmittels auftreten, noch gravierender. Auch die Haftung der Photoresistmaterialien auf den eingangs genannten Substratmaterialien wie z. B. auf Siliciumnitrid, insbesondere auf Plasmanitrid ist sehr problematisch.

Nachdem das Problem der schlechten Haftung von Photoresistmaterialien auf anorganischen Substratmaterialien erkannt wurde, versuchte man zunächst, durch Erwärmen vor der nachfolgenden Ätzung die Haftung zwischen Photoresist und Substratoberfläche zu verbessern, um damit die Verschlechterung der Auflösung durch Abrollen oder Abheben des Photoresists von der Substratoberfläche und eine Unterätzung der Photoresistmaske zu vermeiden. Dieses Erwärmen war jedoch nicht ausreichend, da die Wirkung weitgehend von der Vorbehandlung und von der Oberflächenbeschaffenheit der Oxidschicht abhängig ist. Ausserdem erschwert das Erwärmen auch die spätere Entfernung des Photoresists von der Oberfläche.

Es ist weiterhin bekannt, zur Verbesserung der Haftung von Photoresistmaterialien auf Oberflächen von anorganischen Substratmaterialien eine Haftmittelschicht aufzubringen. So konnte die Haftung von Polyimid auf oxidierten anorganischen Substraten durch Aufbringen einer Siliciumverbindung, welche mit einer über eine Kohlenstoffkette mit dem Silicium verbundenen $NH_2$-Gruppe mit $H_2O$ reagiert, beispielsweise durch Aufbringen von gamma-Aminopropyltriethoxysilan verbessert werden (DE-PS 23 42 801). Aus der DE-OS 2 001 339 ist ein Verfahren zur Verbesserung der Adhäsion von Photolacken auf Oxidoberflächen bekannt, bei dem zur Verbesserung der Haftung Disilylamide, vorzugsweise Bis-(trialkylsilyl)amide eingesetzt werden.

Die besten Ergebnisse hinsichtlich der Haftung von Photoresistmaterialien auf Oxidoberflächen wurden bisher mit Haftvermittlern aus der Gruppe der Hexaalkyldisilazane, vorzugsweise mit Hexamethyldisilazan (HMDS) oder Hexaethyldisilazan (HEDS) erzielt (DE-PS 19 15 085). Es hat sich jedoch gezeigt, dass selbst bei Verwendung von Hexamethyldisilazan als Haftvermittler ein Unterwandern des Photoresists durch Flussäure während des Ätzens der darunterliegenden Siliciumdioxidschicht nicht vollständig verhindert werden kann.

Das Ausmass der Unterwanderung hängt auch in erheblichem Umfang von der Vorbehandlung der Siliciumwafer ab. So kann zur Entfernung von organischen Verunreinigungen von der Waferoberfläche beispielsweise eine Mischung aus einer mindestens 95 %igen Schwefelsäure und aus einer mindestens 30 %igen wässrigen Wasserstoffperoxidlösung in einer auf die wasserfreien Chemikalien bezogenen Volumenmenge von 15 : 1 (DE-PS 23 26 447), oder eine Mischung aus Kaliumpersulfat und konzentrierter Schwefelsäure (DE-OS 27 47 669), gefolgt von Spülung mit DI-Wasser und Vakuumtrocknung, angewendet werden. Es hat sich gezeigt, dass selbst bei dieser Art der Vorbehandlung und bei Verwendung von Hexaalkyldisilazan als Haftvermittler eine nicht tolerierbare Unterätzung, die nur zu einem Bruchteil durch den normalen Angriff des isotropen Ätzmittels bei einer gegebenen Ätzzeit bedingt ist, stattfindet.

Aufgabe der Erfindung ist deshalb ein Verfahren, mit dem gegenüber bisher bekannten Verfahren und den darin verwendeten Haftvermittlern wesentlich verbesserte Ergebnisse hinsichtlich der Haftung von Photoresistmaterialien auf Oberflächen von anorganischen Substratmaterialien erhalten werden.

Die Aufgabe der Erfindung wird gelöst durch ein Verfahren gemäss Patentanspruch 1.

Die in dem erfindungsgemässen Verfahren verwendeten Haftvermittler sind bisher bekannten Haftvermittlern weit überlegen. Die Messergebnisse hinsichtlich der Unterätzung entsprechen theoretischen Erwartungen.

Weitere Einzelheiten und Vorteile der vorliegenden Erfindung sind aus der nachfolgenden Beschreibung, den Figuren und den Beispielen ersichtlich. Die Figuren stellen im einzelnen dar:

Fig. 1 die Herstellung von Ätzmasken für mikromechanische Strukturen;

Fig. 2 in photographischer Darstellung eine mikromechanische Struktur, welche direkt aus einer Siliciumdioxidschicht herausgearbeitet wurde nebst Zeichnung der dazugehörigen Maske;

Fig. 3 Höhendiagramme von Siliciumdioxidstegen, welche aus einer 2 µm dicken Siliciumdioxidschicht herausgearbeitet wurden:

a) Wafer mit HMDS vorbehandelt,

b) Wafer mit HMCTS vorbehandelt;

Fig. 4 in photographischer Darstellung Photoresiststrukturen auf einem Siliciumoxinitridsubstrat;

Fig. 5 die Strukturen von Fig. 4 nach einem Härtetest:

a) Wafer mit HMDS vorbehandelt,

b) Wafer mit HMCTS vorbehandelt.

Wie eingangs abgehandelt wurden bisher als Haftvermittler Hexaalkyldisalazane der allgemeinen Formel

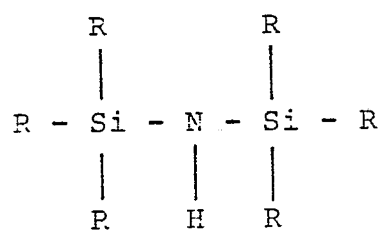

mit R = Methyl (HMDS) oder Ethyl (HEDS) verwendet.

Haftvermittler, die in dem erfindungsgemässen Verfahren Verwendung finden, sind cyclische siliciumorganische Verbindungen der allgemeinen Formel

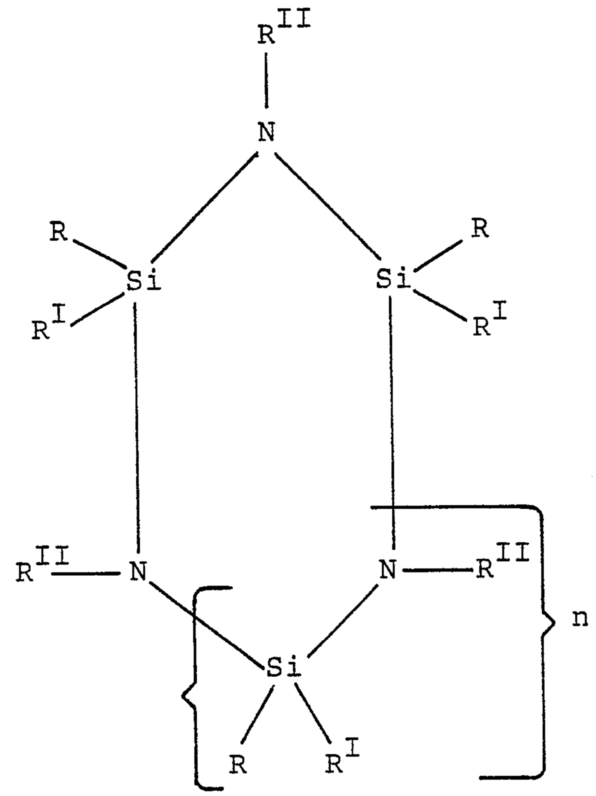

in der R und $R^I$ jeweils H, Alkyl, Cycloalkyl, Aryl, halogensubstituiertes Alkyl oder Aryl, oder Halogen und $R^{II}$ jeweils H, Alkyl oder Aryl bedeuten und n eine ganze Zahl und vorzugsweise 1 oder 2 ist. Weitere cyclische Organosiliciumverbindungen, welche als Haftvermittler Verwendung finden können, sind in der EP-A-86 103 208.4 beschrieben.

In dem erfindungsgemässen Verfahren wird vorzugsweise Hexamethylcyclotrisilazan (HMCTS) verwendet.

Zur Herstellung einer mikromechanischen Struktur wird gemäss Fig. 1A auf einen Siliciumkörper (2) eine Oxid schicht (1) aufgebracht. Diese Oxidschicht kann nach bekannten Verfahren hergestellt werden, wie beispielsweise durch Abscheiden von Siliciumdioxid aus der Dampfphase, durch chemische Oxidation der Siliciumoberfläche mit Sauerstoff, Wasserdampf, Luft oder anderen Oxidationsmitteln oder durch thermische Zersetzung von Silan. Die Dicke der Oxidschicht kann in der Regel zwischen 0,1 und 4 µm liegen. Sie beträgt in diesem Beispiel etwa 2 µm. Nach Herstellung der Oxidschicht wird eine Haftmittelschicht (3) aus Hexamethylcyclotrisilazan (HMCTS) aufgebracht. Das Haftmittel kann entweder direkt oder in Form einer Lösung in einem Lösungsmittel wie Xylol oder einem Chlorfluorkohlenwasserstoff ((Du Pont) Freon$^R$) in einer Verdünnung von 1 Volumteil HMCTS auf 9 Teile Lösungsmittel nach bekannten Beschichtungsverfahren aufgebracht werden. Es genügt, wenn das Haftmittel in einer Schichtdicke von wenigen nm, vorzugsweise nur in Molekülschichtdicke aufgetragen wird.

Eine Vielzahl von Photoresistmaterialien kann über die Haftmittelschicht (3) mit der Oxidschicht (1) verbunden werden. Unter diesen Photoresistmaterialien sind insbesondere Zusammensetzungen auf der Basis von Phenol-Formaldehyd-Polymeren mit Diazoketonderivaten als Sensibilisatoren geeignet, beispielsweise ein Novolakharz mit Naphthochinon-(1,2)-diazid-sulfonsäureester als Sensibilisator, das in der US Patentschrift 3,201,239 beschrieben ist. Ein Photoresistmaterial, das diesen Sensibilisator enthält, ist unter der Bezeichnung Shipley AZ-1350 J Positivphotoresist im Handel erhältlich.

Weitere Polymere, welche über HMCTS als Haftvermittler mit anorganischen Substraten verbunden werden können, sind beispielsweise Polyvinylpyrrolidon, Polyvinylalkohol, Polymere von p-Hydroxystyrol, Melaminpolymere, Homo-und Copolymere von monoethylenisch ungesättigten Säuren wie Copolymere von Alkylmethacrylaten und Acryl-bzw. Methacrylsäure oder Crotonsäure.

Die Dicke des aufzubringenden Photoresists hängt von dem speziellen Material und der Beschichtungstechnik ab. Normalerweise sind bei der Herstellung mikromechanischer Strukturen Dicken zwischen 100 und 1000 nm ausreichend. Anschliessend wird die Photoresistschicht (4) in dem gewünschten Muster bildmässig belichtet, mit einem alkalischen Entwickler entwickelt und nachgehärtet. Die Oberfläche

der Wafer wird dann einer Ätzlösung zum Ätzen des Oxids (1) ausgesetzt. Als Ätzmittel zum Ätzen der Maskenstruktur in die 2 µm Siliciumdioxidschicht (1) wird beispielsweise eine mit Ammoniumfluorid gepufferte Flussäure verwendet. Zum Ätzen können auch Mischungen von Salpetersäure, Essigsäure und Flussäure verwendet werden.

Es hat sich gezeigt, dass die Photoresistmaske (4) während des Ätzens der Maskenstruktur in die Siliciumdioxidschicht (1) fest mit der Oxidoberfläche verbunden bleibt. Ein Abheben des Photoresists, wie es in Fig. 1 B dargestellt ist, findet bei Verwendung der erfindungsgemässen Haftmittelschicht (3) aus HMCTS nicht statt.

Nach dem Strippen der Photoresistmaske (4) wird mit einem für das Substratmaterial (2) geeigneten Ätzmittel, z. B. mit KOH (44 gew.%ig in Wasser/Isopropanol) durch die Siliciumdioxidmaske (1) das gewünschte Muster in den Siliciumkörper (2) geätzt (Fig. 1 C).

Fig. 2 zeigt in photographischer Darstellung (200 : 1) eine freitragende, etwa 2 µm dicke Siliciumdioxidzunge über einer etwa 26 µm tiefen Ätzgrube im Siliciumsubstrat. Zur Herstellung dieser mikromechanischen Struktur wird eine Siliciumdioxidmaske, deren Muster unter der Photographie abgebildet ist, auf nasschemischem Wege durch Ätzen in gepufferter Flussäure erzeugt. Hierzu wird eine Photoresistmaske, welche in bekannter Weise und unter Verwendung einer HMCTS-Haftmittelschicht hergestellt wurde, als Ätzmaske verwendet. Mit einem anisotropen Ätzmittel wird durch diese Maske in das (100) Siliciumsubstrat geätzt. Als Ätzmittel wird 44 %ige Kalilauge verwendet. Ätzzeit und Temperatur betragen 5,3 Stunden bzw. 40 °C. Da die Maske um 45 ° zur <110> Kristallrichtung gedreht ist, findet in erheblichem Masse eine Unterätzung der Maske statt. Auf diese Weise wird während der langen Ätzzeit eine freitragende Zunge aus Siliciumdioxid über einer Ätzgrube im Substratmaterial von etwa 26 µm Tiefe erhalten. Die in Fig. 2 im Masstab 200 : 1 abgebildete Zunge weist eine Breite von etwa 50 µm und eine Länge von etwa 500 µm auf. Sie wurde in einer Schichtdicke von 0.2 µm mit Gold bedampft. Das Mikroskopbild ($512^{x}$) dieser Zunge zeigt eine Struktur mit scharfen Kanten, was darauf zurückzuführen ist, dass keine Unterwanderung der Photoresistmaske stattgefunden hat. Die in diesem Beispiel verwendeten Siliciumwafer wurden auch nicht mit Caro'scher Säure vorbehandelt, so dass die vorteilhaften Ergebnisse ausschliesslich auf die Verwendung des erfindungsgemässen HMCTS-Haftvermittlers zurückzuführen sind.

Die Ueberlegenheit von Hexamethylcyclotrisilazan (HMCTS) als Haftvermittler kann auch durch direkten Vergleich mit Hexamethyldisilazan (HMDS) gezeigt werden. In Fig. 3 sind Höhendiagramme von Siliciumdioxidstegen, welche aus einer 2 µm dicken Siliciumdioxidschicht herausgearbeitet wurden, dargestellt. Die Höhendiagramme wurden mit dem mechanischen Tastschrittgerät α-step 200 der Fa. Tencor aufgenommen. Die Siliciumdioxidstege befinden sich auf zwei verschiedenen Wafern, welche in identischen Verfahren prozessiert wurden, mit der Ausnahme, dass Wafer A mit HMDS und Wafer B mit HMCTS als Haftvermittler behandelt wurde. Die Stege sind nominell 25 µm breit und weisen nach dem Ätzen eine Sollunterätzung von insgesamt 4.4 µm auf. Bei Wafer B, welcher mit HMCTS vorbehandelt wurde, entsprechen die Messergebnisse nahezu den theoretischen Erwartungen, während bei Wafer A, welcher mit HMDS vorbehandelt wurde, zusätzlich eine Unterätzung von etwa 5 µm gemessen wurde, die auf die Unterätzung der Photoresistmaske zurückzuführen ist.

Mit HMCTS wird auch auf Siliciumoxinitridschichten eine wesentlich bessere Haftung des Photoresists als mit HMDS als Haftvermittler erhalten. Um dies zu belegen, wurden mehrere mit Oxinitrid beschichtete Wafer (Schichtdicke etwa 2 µm, Brechungsindex 1.758) mit Shipley AZ 1350 J Positivphotoresist beschichtet, belichtet, entwickelt und nachgehärtet. Als Haftvermittler wurden sowohl HMDS wie auch HMCTS, gelöst in Freon$^{R}$ , verwendet. Die kleinsten Strukturen auf der Photomaske hatten eine Linienbreite von 2.5 µm. Nach dem Entwickeln und einer Nachhärtung bei 130 °C waren zunächst auf allen Wafern die kleinsten Photoresiststrukturen mit einer Linienbreite von 3.0 µm einwandfrei erhalten (Fig. 4). Anschliessend wurden alle Wafer mit den Resiststrukturen noch einmal eine Stunde lang bei Zimmertemperatur in die Entwicklerlösung (Natriummetasilikat/Natriumphosphat) gelegt und danach gründlich mit DI-Wasser gespült. Bei dieser Stressbehandlung zeigte sich deutlich die Überlegenheit mit HMCTS behandelter Wafer gegenüber mit HMDS behandelten Wafern. Bei mit HMDS behandelten Wafern (Fig. 5, A) waren alle Resiststrukturen einschliesslich einer Linienbreite von 4.5 µm verschwunden, während bei den mit HMCTS als Haftvermittler behandelten Wafern selbst die 3.0 µm breiten Photoresiststrukturen (Fig. 5, B) noch vorhanden waren.

Obwohl die Erfindung in ihrer Anwendung zur Herstellung von Halbleiteranordnungen und mikromechanischen Strukturen beschrieben wurde, kann sie auch in anderen Verfahren angewendet werden, bei denen eine Photoresistschicht auf eine Oberfläche von anorganischen Substratmaterialien aufgebracht werden muss. So kann beispielsweise das Verfahren gemäss der Erfindung bei der Herstellung gedruckter Schaltkarten, zur Herstellung von Dünnschichtspeichern, bei denen ein Metallfilm durch eine Oxidoberfläche geschützt wird, beim Tiefdruckverfahren, oder bei der Herstellung von Photomasken und zur

Beschichtung von Glasplatten verwendet werden. Die Datenspeicherung auf optischen Platten beispielsweise verlangt sehr kleine (0.6 µm breite) Strukturen, welche in das Glassubstrat eingeätzt werden müssen. Es wurde versucht, die zum Testen des Abtastverhaltens optischer Platten erforderlichen 1 µm breiten Rillen mittels herkömmlicher Lithographie in das Glassubstrat zu ätzen, was mit HMDS als Haftvermittler nicht gelang. Mit Hilfe des erfindungsgemässen Haftvermittlers HMCTS dagegen konnten diese 1 µm breiten Rillen in das Glassubstrat geätzt werden.

Die cyclischen siliciumorganischen Verbindungen, welche in dem erfindungsgemässen Verfahren als Haftvermittler zur Anwendung kommen, müssen wenigstens zwei funktionelle Gruppen enthalten oder bereitstellen können, welche mit den reaktiven Gruppen des Polymerresists reagieren können, während der verbleibende Rest des Moleküls fest an dem anorganischen Substratmaterial haftet.

Der erfindungsgemässe Haftvermittler ist allgemein anwendbar und brauchbar für die Verbesserung der Haftung von Polymermaterialien auf Oberflächen von anorganischen Substratmaterialien.

## Ansprüche

1. Verfahren zur Verbesserung der Haftung von Photoresistmaterialien auf Oberflächen von anorganischen Substratmaterialien, dadurch gekennzeichnet, dass auf die Oberfläche des Substratmaterials als Haftvermittler eine cyclische siliciumorganische Verbindung der allgemeinen Formel

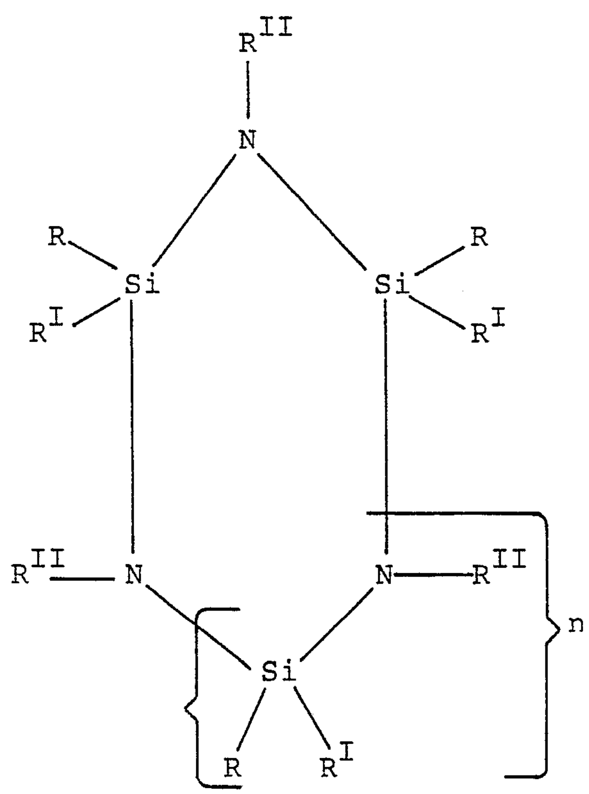

in der R und $R^I$ jeweils H, Alkyl, Cycloalkyl, Aryl, halogensubstituiertes Alkyl oder Aryl, oder Halogen und $R^{II}$ jeweils H, Alkyl oder Aryl bedeuten und n eine ganze Zahl und vorzugsweise 1 oder 2 ist, aufgebracht wird.

2. Verfahren nach Anspruch 1, dadurch gekennzeichnet, dass als cyclische siliciumorganische Verbindung Hexamethylcyclotrisilazan (HMCTS) aufgebracht wird.

3. Verfahren nach Anspruch 2, dadurch gekennzeichnet, dass HMCTS direkt, oder gelöst in Xylol oder einem Chlorfluorkohlenwasserstoff aufgebracht wird.

4. Verfahren nach Anspruch 3, dadurch gekennzeichnet, dass eine Lösung von einem Volumteil HMCTS in 9 Volumteilen Lösungsmittel verwendet wird.

5. Verfahren nach Anspruch 1, dadurch gekennzeichnet, dass als Photoresistmaterialien Zusammensetzungen auf der Basis von Phenol-Formaldehyd-Polymeren mit Diazoketonderivaten als Sensibilisatoren verwendet werden.

6. Verfahren nach Anspruch 1, dadurch gekennzeichnet, dass die anorganischen Substratmaterialien aus der Gruppe von polykristallinem Silicium, Siliciumnitrid, Siliciumoxinitrid, Siliciumdioxid, Quarz, Phosphorsilikatglas und dergl. gewählt sind.

7. Verfahren zur Herstellung von mikromechanischen Strukturen, bei dem durch eine Siliciumdioxidmaske ein gewünschtes Muster in einen Siliciumkörper geätzt wird, dadurch gekennzeichnet, dass die Siliciumdioxidmaske hergestellt wird, indem eine Siliciumdioxidschicht auf einem Siliciumkörper gebildet und die Oxidoberfläche mit HMCTS überzogen wird, auf der HMCTS-Schicht eine Photoresistschicht gebildet wird und der Photoresist belichtet, entwickelt und nachgehärtet wird und das Siliciumdioxid durch die Photoresistmaske unter Bildung der Siliciumdioxidmaske geätzt wird.

8. Verfahren nach Anspruch 7, dadurch gekennzeichnet, dass die Siliciumdioxidschicht eine Schichtdicke von 2 µm aufweist.

9. Haftvermittler zur Verbesserung der Haftung von Photoresistmaterialien auf Oberflächen von anorganischen Substratmaterialien gekennzeichnet durch die allgemeine Formel

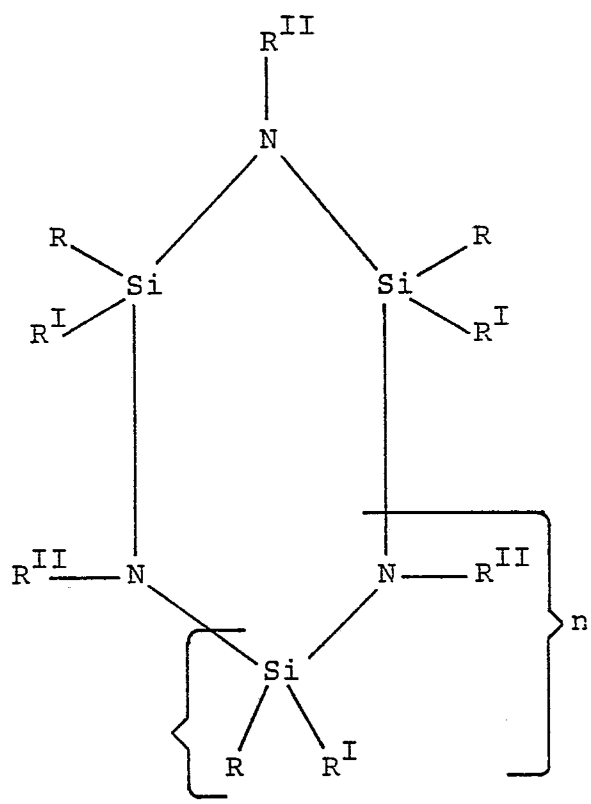

in der R und $R^I$ jeweils H, Alkyl, Cycloalkyl, Aryl, halogensubstituiertes Alkyl oder Aryl, oder Halogen und $R^{II}$ jeweils H, Alkyl oder Aryl bedeuten und n eine ganze Zahl und vorzugsweise 1 oder 2 ist.

10. Haftvermittler nach Anspruch 9, dadurch gekennzeichnet, dass die siliciumorganische Verbindung Hexamethylcyclotrisilazan (HMCTS) ist.

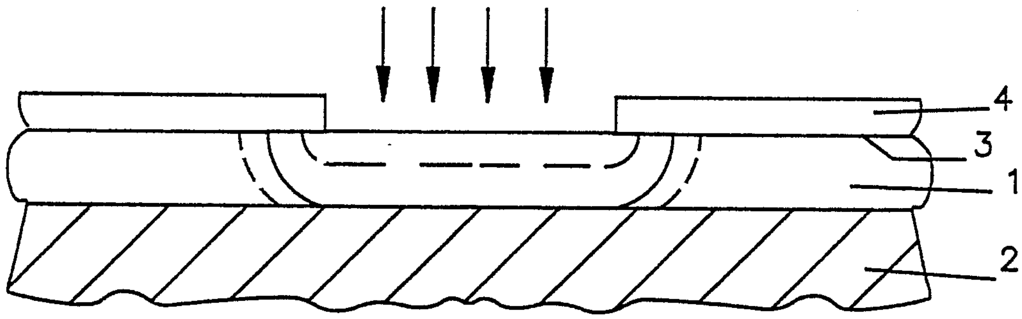


FIG. 1A

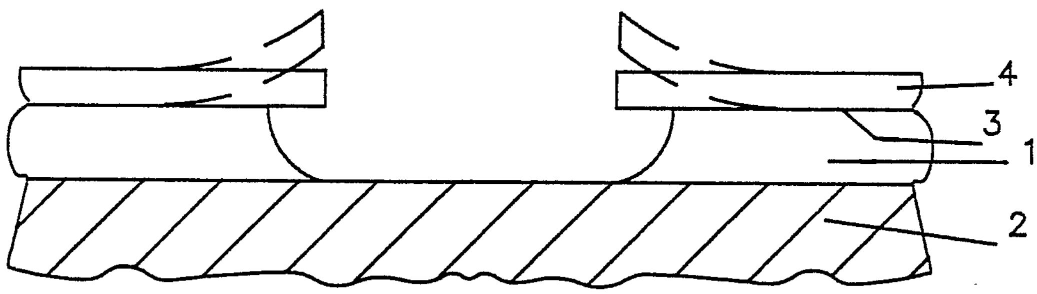


FIG. 1B

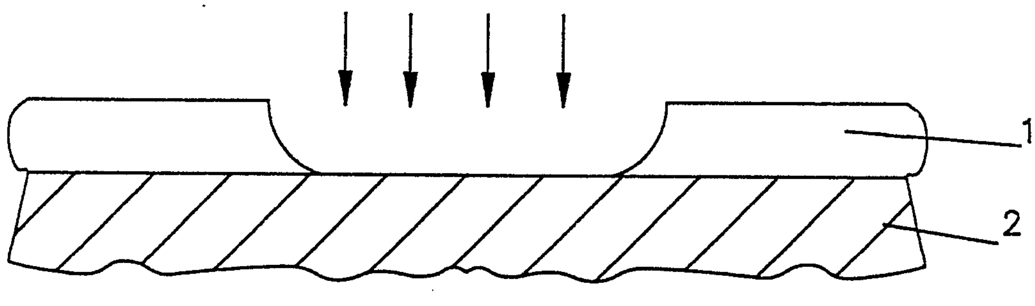


FIG. 1C

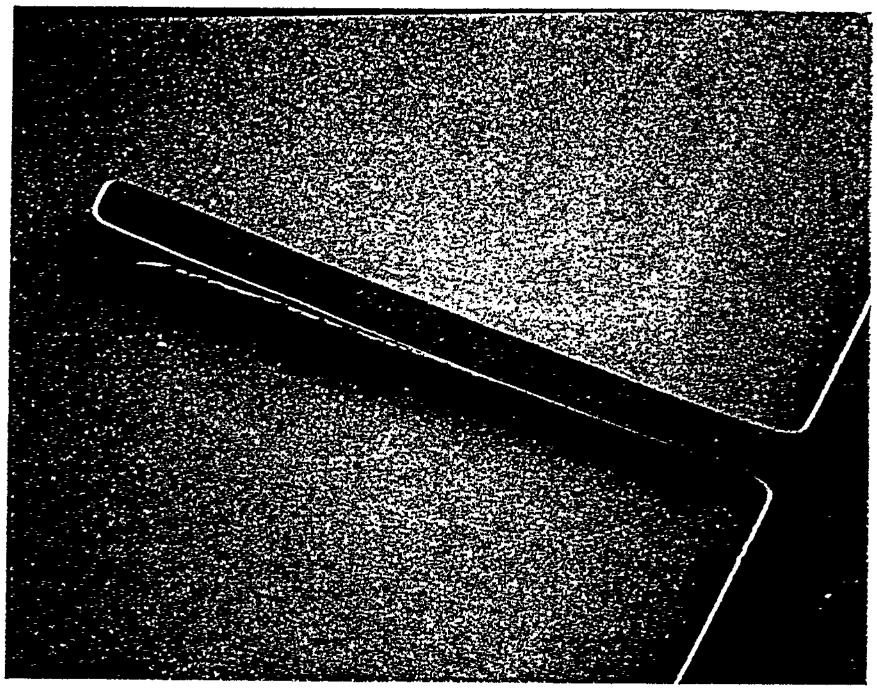

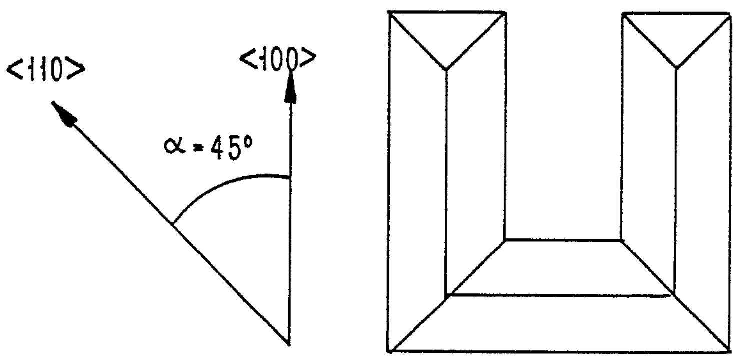


FIG. 2

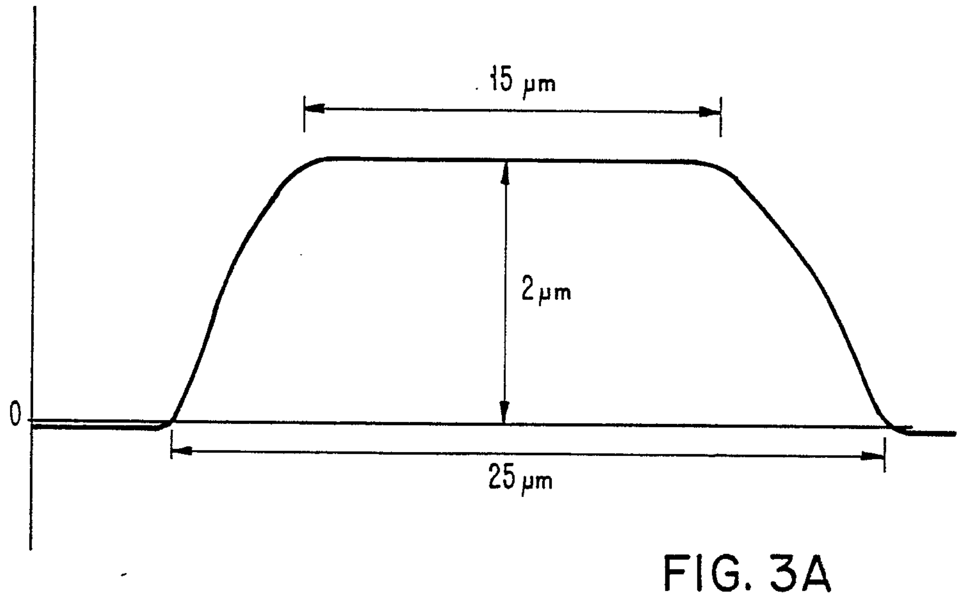


FIG. 3A

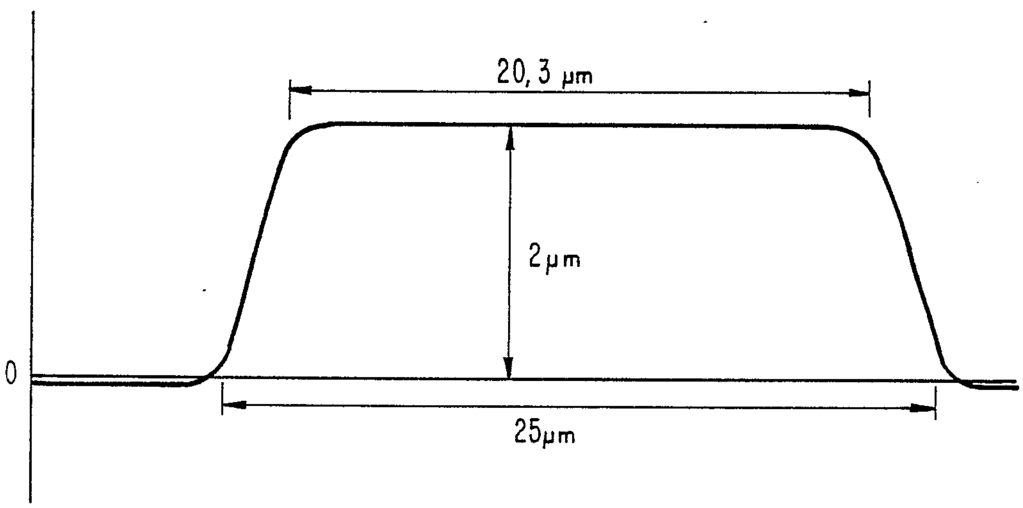


FIG. 3B

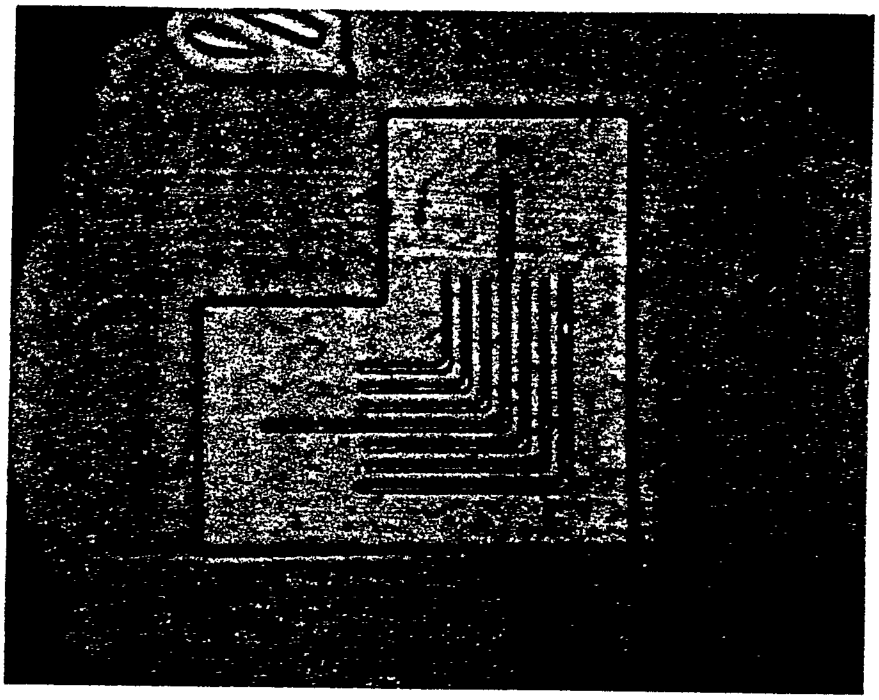

FIG. 4

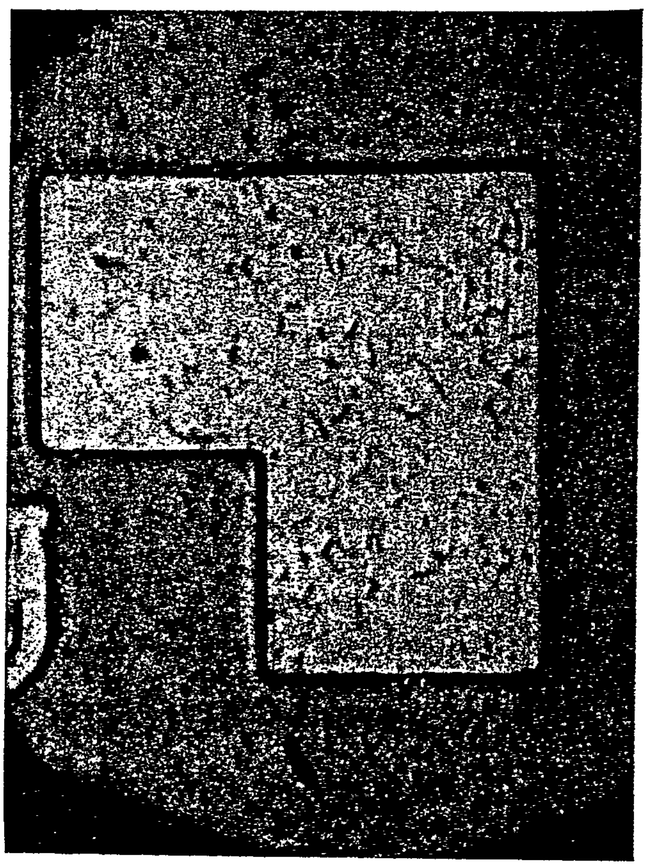

FIG.5A

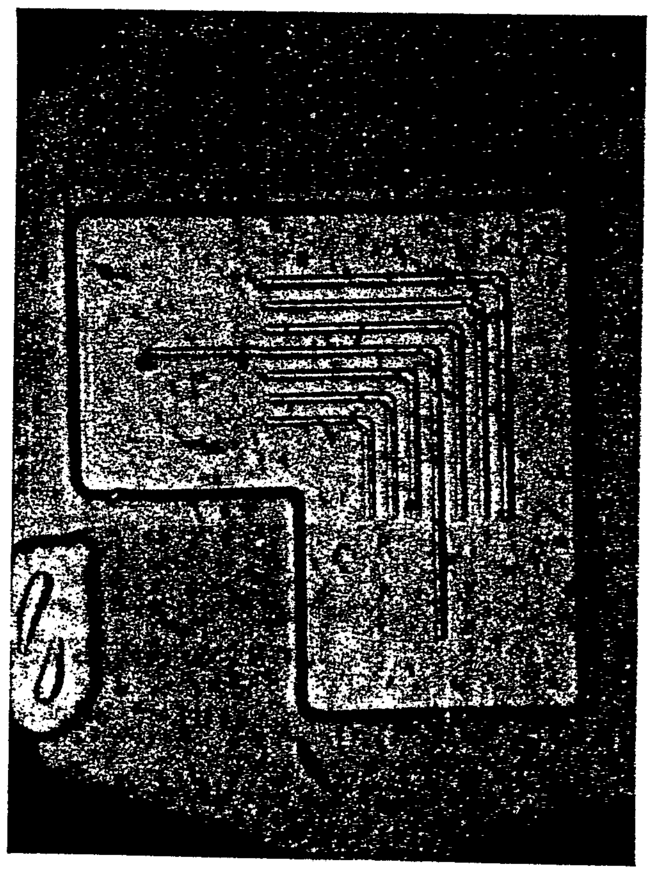

FIG. 5B

Europäisches Patentamt

# EUROPÄISCHER RECHERCHENBERICHT

Nummer der Anmeldung

EP 87 10 2190

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 103 045 (A. LESAICHERRE et al.) * Spalte 2, Zeile 65 - Spalte 3, Zeile 3; Spalte 4, Zeilen 26-35; Ansprüche * | 1-10 | G 03 F 7/02 |
| | ----- | | |
| | | | RECHERCHIERTE SACHGEBIETE (Int. Cl.4) |
| | | | G 03 F 7/02 |

Der vorliegende Recherchenbericht wurde für alle Patentansprüche erstellt.

| Recherchenort | Abschlußdatum der Recherche | Prüfer |
|---|---|---|
| DEN HAAG | 08-10-1987 | RASSCHAERT A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82